# EUROPEAN PATENT APPLICATION

(11) **EP 4 723 826 A1**
(43) Date of publication of application: **08.04.2026**
(21) Application number: 25168190.4
(22) Date of filing: 03.04.2025
(51) Int. Cl.: H10D 10/01, H10D 62/10, H10D 10/80, H10D 62/17

(54) **BIPOLAR TRANSISTOR STRUCTURES WITH SEMICONDUCTOR FILM AND RELATED METHODS**

(30) Priority: 03.10.2024 US 202418905278
(71) Applicant: GlobalFoundries U.S. Inc., Malta, NY 12020 (US)
(72) Inventor: Shank, Steven M., Essex Junction 05452 (US); DeAngelis, Jacob M., Essex Junction 05452 (US); Raghunathan, Uppili S., Essex Junction 05452 (US); McTaggart, Sarah A., Essex Junction 05452 (US); Lydon-Nuhfer, Megan Elizabeth, Essex Junction 05452 (US); Luce, Cameron, Essex Junction 05452 (US); Jain, Vibhor, Malta 12020 (US)
(74) Representative: Grünecker Patent- und Rechtsanwälte PartG mbB

(57) **Abstract**

The disclosure provides bipolar transistor structures with a semiconductor film, and related methods. A structure of the disclosure includes an intrinsic base on a collector. The collector has a first doping type. A semiconductor film is on the intrinsic base and horizontally surrounds the intrinsic base. The semiconductor film horizontally encapsulates the intrinsic base. An emitter having the first doping type is on a first portion of the semiconductor film. An extrinsic base having a second doping type is on a second portion of the semiconductor film.

## Description

### BACKGROUND

The present disclosure relates to bipolar transistor structures and methods to form such structures.

Present technology is at atomic level scaling of certain micro-devices such as logic gates, bipolar transistors, field effect transistors (FETs), and capacitors. Circuit chips with millions of such devices are common. The structure of a bipolar transistor defines several of its properties during operation. Bipolar transistors typically include multiple materials within its base terminal, i.e., the terminal for controlling current flow between the emitter and collector terminals of the bipolar transistor. A base terminal includes a relatively high conductivity extrinsic base having a terminal thereto, and a relatively low conductivity intrinsic base connected to the extrinsic base and located between the emitter and collector. Epitaxial growth of the extrinsic base on the intrinsic base, in some cases, may pose a risk of electrical shorting of the intrinsic base to any foundational materials (e.g., subcollector) located below the transistor.

### SUMMARY

The illustrative aspects of the present disclosure are designed to solve the problems herein described and/or other problems not discussed.

Embodiments of the disclosure provide a structure including: an intrinsic base on a collector, wherein the collector has a first doping type; a semiconductor film on the intrinsic base and horizontally surrounding the intrinsic base; an emitter having the first doping type on a first portion of the semiconductor film; and an extrinsic base having a second doping type on a second portion of the semiconductor film.

Other embodiments of the disclosure provide a structure including: a collector on a subcollector, the collector having a first doping type; an intrinsic base on the collector, the intrinsic base having a second doping type; a semiconductor film on the intrinsic base and horizontally surrounding the intrinsic base; an dielectric layer on the subcollector and horizontally distal to the collector, wherein an air gap is between the collector and the dielectric layer; an emitter having the first doping type on a first portion of the semiconductor film, wherein the first portion of the semiconductor film includes the first doping type and the second doping type; and an extrinsic base having the second doping type on a second portion of the semiconductor film, wherein the second portion of the semiconductor film includes only the second doping type.

Additional embodiments of the disclosure provide a method including: forming an intrinsic base on a collector, wherein the collector has a first doping type; forming a semiconductor film on the intrinsic base and horizontally surrounding the intrinsic base; forming an emitter having the first doping type on a first portion of the semiconductor film; and forming an extrinsic base having a second doping type on a second portion of the semiconductor film.

### BRIEF DESCRIPTION OF THE DRAWINGS

These and other features of this disclosure will be more readily understood from the following detailed description of the various aspects of the disclosure taken in conjunction with the accompanying drawings that depict various embodiments of the disclosure, in which:
FIG. 1 depicts a cross-sectional view in plane X-Z of a structure according to embodiments of the disclosure.
FIG. 2 depicts cross-sectional view in plane X-Y of a structure according to embodiments of the disclosure.
FIG. 3 depicts a cross-sectional view in plane X-Z, from view line 2-2 of FIG. 1, of a structure according to further embodiments of the disclosure.
FIGS. 4-9 depict cross-sectional views in plane X-Z of processes in methods to form a structure according to embodiments of the disclosure.
FIGS. 10-13 depict cross-sectional views in plane X-Z of processes in methods to form a structure according to further embodiments of the disclosure.
It is noted that the drawings of the disclosure are not necessarily to scale. The drawings are intended to depict only typical aspects of the disclosure, and therefore should not be considered as limiting the scope of the disclosure. In the drawings, like numbering represents like elements between the drawings.

### DETAILED DESCRIPTION

**In** the following description, reference is made to the accompanying drawings that form a part thereof, and in which is shown by way of illustration specific illustrative embodiments in which the present teachings may be practiced. These embodiments are described in sufficient detail to enable those skilled in the art to practice the present teachings, and it is to be understood that other embodiments may be used and that changes may be made without departing from the scope of the present teachings. The following description is, therefore, merely illustrative.

It will be understood that when an element such as a layer, region, or substrate is referred to as being "on" or "over" another element, it may be directly on the other element or intervening elements may also be present. In contrast, when an element is referred to as being "directly on" or "directly over" another element, there may be no intervening elements present. It will also be understood that when an element is referred to as being "connected" or "coupled" to another element, it may be directly connected or coupled to the other element or intervening elements may be present. In contrast, when an element is referred to as being "directly connected" or "directly coupled" to another element, there are no intervening elements present.

Reference in the specification to "one embodiment" or "an embodiment" of the present disclosure, as well as other variations thereof, means that a particular feature, structure, characteristic, and so forth described in connection with the embodiment is included in at least one embodiment of the present disclosure. Thus, the phrases "in one embodiment" or "in an embodiment," as well as any other variations appearing in various places throughout the specification are not necessarily all referring to the same embodiment. It is to be appreciated that the use of any of the following "/," "and/or," and "at least one of," for example, in the cases of "A/B," "A and/or B" and "at least one of A and B," is intended to encompass the selection of the first listed option (a) only, or the selection of the second listed option (B) only, or the selection of both options (A and B). As a further example, in the cases of "A, B, and/or C" and "at least one of A, B, and C," such phrasing is intended to encompass the first listed option (A) only, or the selection of the second listed option (B) only, or the selection of the third listed option (C) only, or the selection of the first and the second listed options (A and B), or the selection of the first and third listed options (A and C) only, or the selection of the second and third listed options (B and C) only, or the selection of all three options (A and B and C). This may be extended, as readily apparent by one of ordinary skill in the art, for as many items listed.

The disclosure provides bipolar transistor structures with a semiconductor film, and related methods. A structure of the disclosure includes an intrinsic base on a collector. The collector has a first doping type and the intrinsic base has a second doping type. A semiconductor film is on the intrinsic base and horizontally surrounds the intrinsic base. The semiconductor film horizontally encapsulates the intrinsic base. An emitter having the first doping type is on a first portion of the semiconductor film. An extrinsic base having the second doping type is on a second portion of the semiconductor film.

Bipolar junction transistor (BJT) structures, such as those in embodiments of the disclosure, operate using multiple "P-N junctions." The term "P-N" refers to two adjacent materials having different types of conductivity (i.e., P-type and N-type), which may be induced through dopants within the adjacent material(s). A P-N junction, when formed in a device, may operate as a diode. A diode is a two-terminal element, which behaves differently from conductive or insulative materials between two points of electrical contact. Specifically, a diode provides high conductivity from one contact to the other in one voltage bias direction (i.e., the "forward" direction), but provides little to no conductivity in the opposite direction (i.e., the "reverse" direction). In the case of the P-N junction, the orientation of a diode's forward and reverse directions may be contingent on the type and magnitude of bias applied to the material composition of one or both terminals, which affects the size of the potential barrier. In the case of a junction between two semiconductor materials, the potential barrier will be formed along the interface between the two semiconductor materials. Generally, a BJT structure includes a base region vertically or horizontally between emitter and collector materials. A BJT can be either a PNP-type BJT or an NPN-type BJT. In a PNP-type BJT, the emitter and collector regions have P-type conductivity and at least a portion of the base region has N-type conductivity. In an NPN-type BJT, the emitter and collector regions have N-type conductivity and at least a portion of the base has P-type conductivity.

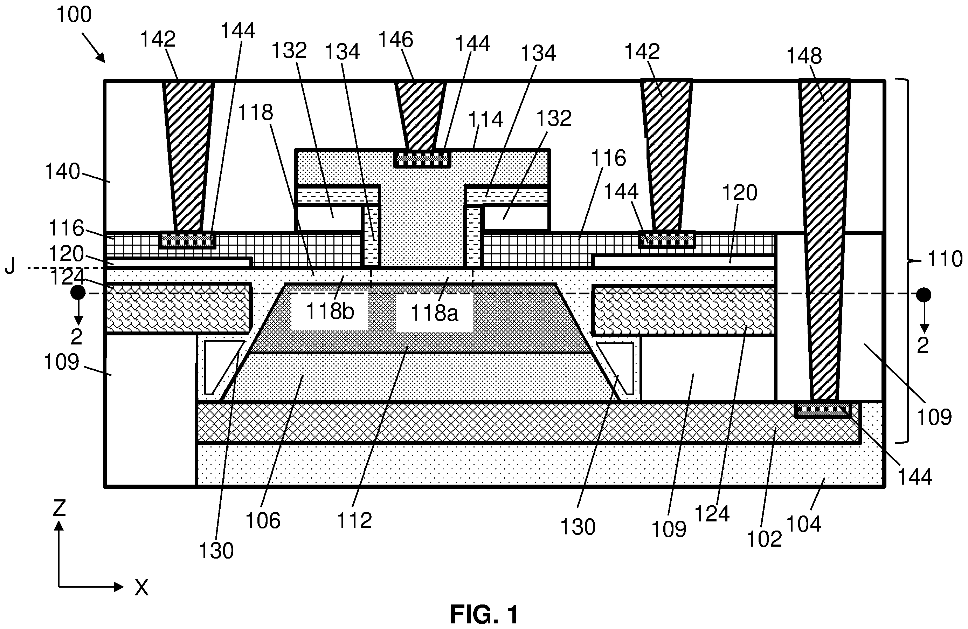

Referring to FIG. 1, a structure 100 according to the disclosure may include a bipolar transistor 110 (e.g., a vertically oriented bipolar transistor as discussed herein) in which a semiconductor film 118 is positioned on, and horizontally surrounds, the intrinsic base and, optionally, collector 106. Below the emitter of the transistor, the semiconductor film 118 may include P-type and N-type dopants (e.g., due to ion migration during processing) but may include only one doping type elsewhere. Structure 100 may be formed on a subcollector 102 (i.e., a doped portion of a semiconductor substrate) including, e.g., one or more monocrystalline semiconductor materials. Subcollector 102 may include but is not limited to silicon, germanium, silicon germanium (SiGe), silicon carbide, or any other common IC semiconductor substrates. In the case of SiGe, the germanium concentration in subcollector 102 may differ from other SiGe-based structures described herein. A portion or entirety of subcollector 102 may be strained. Subcollector 102 may be doped (i.e., it may define a "doped well" ), e.g., to enable coupling to the lower active semiconductor materials of a vertical bipolar transistor. Subcollector 102 may have any conceivable doping type and/or doping composition appropriate for use within and/or coupling to the collector terminal of a bipolar transistor. For instance, subcollector 102 may have the same dopant type as a collector 106 formed thereon, e.g., P-type doping in the case of a PNP-type BJT or N-type doping in the case of an NPN-type BJT, and/or may have a higher or lower dopant concentration therein.

Collector 106 may be on subcollector 102, e.g., as a single layer or multiple similarly doped but distinct layers formed by epitaxial deposition of silicon, SiGe, and/or other semiconductor materials on subcollector 102 and may have a predetermined doping type, e.g., by being doped in-situ or during formation of semiconductor material(s) of subcollector 102 and/or subcollector 102. Collector 106 is monocrystalline in structure. Collector 106 may define active semiconductor material of a vertical bipolar transistor, and thus may be vertically below other terminals (i.e., intrinsic base, extrinsic base, and emitter terminals discussed herein) of bipolar transistor 110. Collector 106 is illustrated as having tapered sidewalls over subcollector 102, e.g., as a result of being formed by epitaxial deposition and growth. However, collector 106 may have other shapes as a result of varying manufacturing techniques.

Isolation layer 109, which optionally may be subdivided into multiple layers and/or materials of varying width and/or depth, may also be on subcollector 102 to horizontally separate various active semiconductor materials on substrate 104. As shown, some isolation layers 109 may extend vertically into substrate 104, whereas others may be located on subcollector 102 to prevent electrical shorting between subcollector 102 and overlying areas of bipolar transistor 110. As discussed elsewhere herein isolation layer 109 initially may extend over substrate 104 as a single layer. Portions of isolation layer 109 may be removed to form a trench, which may undercut certain remaining portions of isolation layer 109 near subcollector 102. The undercut portions of isolation layer 109 may form substantially triangular divots, recesses, etc., where collector 106 material may be grown. Thus, collector 106 when formed may have a tapered or sloped shape, as shown. In cases where collector 106 has tapered sidewalls, various materials on collector 106 (e.g., intrinsic base 112 discussed herein) also may have tapered sidewall profiles, e.g., by selective epitaxial growth of additional material on collector 106.

Bipolar transistor 110 may include an intrinsic base 112 on collector 106. Intrinsic base 112 may include, e.g., monocrystalline SiGe or any other monocrystalline semiconductor material that is doped to have a predetermined polarity. Intrinsic base 112 may include a different semiconductor material (e.g., silicon germanium as opposed to silicon) than collector and 106 and an emitter 114 thereover. The use of differing semiconductor materials at the emitter-base junction and at the base-collector junction creates heterojunctions, which are, for example, suitable for handling higher frequencies. In this case, the BJT is referred to in the art as a heterojunction bipolar transistor (HBT). In the case where the bipolar transistor is an NPN-type transistor and subcollector 102, collector 106, and emitter 114 are doped n-type, intrinsic base 112 may be doped p-type to form a P-N junction, and hence a base-to-collector interface. It is also understood that intrinsic base 112 may be doped n-type in the case where the bipolar transistor is a PNP-type transistor. However embodied, intrinsic base 112 may extend to a predetermined height over collector 106, and as discussed herein intrinsic base 112 may have sloped or otherwise tapered sidewalls similar to, and/or substantially aligned with those of collector 106 thereunder.

Intrinsic base 112 may be structurally and compositionally distinct from other portions of a base terminal for bipolar transistor 110. Intrinsic base 112 in particular may be lightly doped, or possibly undoped, whereas an extrinsic base 116 on intrinsic base 112 may be doped more highly than intrinsic base 112. Intrinsic base 112 may be formed, e.g., by forming a layer of semiconductor material, which may be monocrystalline silicon or SiGe as discussed herein, on collector 106. Additional semiconductor material may be formed through selective epitaxial growth and/or similar processes to form additional semiconductor material while preserving the crystallographic orientation and/or composition of the underlying material(s). Selective epitaxial growth of intrinsic base 112 in particular may maintain the shape and orientation of the sidewalls of collector 106.

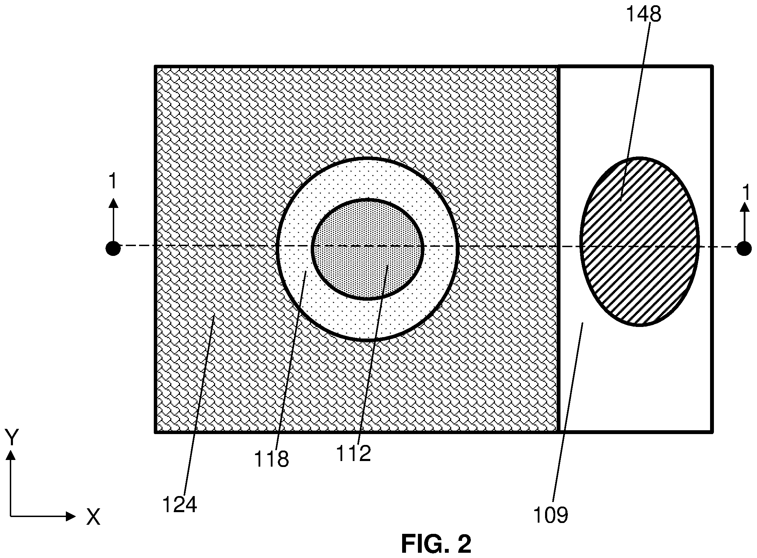

Referring to FIGS. 1 and 2 together, a semiconductor film 118 (e.g., a layer of crystalline silicon and/or other semiconductor having a different composition from intrinsic base 112) may be on intrinsic base 112. Semiconductor film 118 may be grown, e.g., by non-selective deposition, epitaxial growth, etc., of silicon or similar semiconductor material(s) such that semiconductor film 118 is formed on upper surfaces and sidewalls of components having exposed surfaces at the time semiconductor film 118 is formed. Semiconductor film 118 may be crystalline only where grown and/or in contact with other crystalline materials, but otherwise may be polycrystalline in structure (e.g., where grown on, or in contact with, dielectric materials). As shown specifically in FIG. 2, semiconductor film 118 may horizontally surround intrinsic base 112 such that the top surface and upper sidewalls of intrinsic base 112 are immediately adjacent (e.g., in physical contact with) semiconductor film 118. Semiconductor film 118, in certain portions thereof, may have a similar conductivity and/or doping concentration as intrinsic base 112 but may include a different semiconductor material to function as an etch stop layer and/or intermediate material with varying dopants to enable forming of emitter 114 (FIG. 1) and extrinsic bases 116 thereon on different locations. Semiconductor film 118 in particular may feature a substantially planar upper surface (e.g., coincident with line J (FIG. 1) as illustrated) on which additional components can be formed with similarly planar surfaces. This, in turn, allows only a portion of extrinsic base materials and/or other materials formed on semiconductor film 118 to be removed, modified, etc., to provide additional portions of bipolar transistor 110 in varying configurations as discussed herein. During operation, semiconductor film 118 may have a same or similar conductivity as semiconductor film 112 and thus semiconductor film 118, during operation, may be considered to be a portion of intrinsic base 112.

Extrinsic base(s) 116 of bipolar transistor 110 may be on respective portions of semiconductor film 118. Extrinsic base(s) 116 may include a polycrystalline semiconductor (e.g., polycrystalline SiGe) with a relatively high amount of the same doping type as (e.g., more p-type doping than) intrinsic base 112. Extrinsic base(s) 116 may be formed, e.g., by depositing an initial (seed) layer of monocrystalline and/or other semiconductor materials on intrinsic base 112 and/or semiconductor film 118. Through selective epitaxial growth, deposition, and/or other processing, extrinsic base(s) 116 can be formed from the initial layer to a desired height. Extrinsic base 116, by being formed through selective epitaxial growth may have sidewalls that are similarly shaped and/or substantially aligned with the sloped sidewalls of intrinsic base 112 and collector 106 thereunder.

Optionally, some portions of semiconductor film 118 may have an insulator film 120 thereon. Insulator film 120 may be vertically interposed between semiconductor film 118 and any portion(s) of extrinsic base(s) 116 thereover. Insulator film may have the same composition, or a similar composition, as isolation layer(s) 109 discussed herein. Insulator film 120 may be present, e.g., to restrict the contact area between extrinsic base(s) 116 and semiconductor film 118 to reduce the electrical resistance and/or parasitic losses between extrinsic base(s) 116 and intrinsic base 112 during operation of bipolar transistor 110. Insulator film 120 may be located, e.g., on an upper surface of semiconductor film 118, but insulator film 120 may be formed in positions and/or configurations. In some implementations, insulator film 120 may be omitted entirely.

Dielectric layer 124 may be located on isolation layer 109, above subcollector 102. Dielectric layer 124 may have a similar composition to isolation layer 109 or may be formed of a different material. For instance, dielectric layer 124 may be a nitride-based insulator whereas isolation layer 109 may be an oxide-based insulator. As semiconductor film 118 is formed, e.g., by deposition on vacant spaces, limited space between intrinsic base 112 and dielectric layer 124 may prevent semiconductor film 118 from completely filling underlying space horizontally between collector 106 and isolation layer 109. Remaining space below dielectric layer 124, not filled by semiconductor film 118 or other semiconductive or conductive materials, may form an air gap 130 horizontally between isolation layer 109 and extrinsic base 116. In other implementations, portions of dielectric layer 124 may be removed (e.g., it may be undercut during etching as discussed herein) to form air gap 130 before collector 106 and intrinsic base 112 are formed on subcollector 102.

Air gap 130 refers to a region of space surrounded by, and hence not filled with, solid materials such as isolation layer 109, dielectric layer 124, etc. Air gap 130 may be formed by any conceivable method to enclose and/or seal off a desired space to prevent additional materials from being formed therein. For instance, the horizontal space between dielectric layer 124 and intrinsic base 112 may be significantly less than that of the horizontal space between collector 106 and isolation layer 109. By forming semiconductor film 118 on these components (e.g., by conformal deposition and/or other processing techniques described herein), semiconductor film 118 will fill and occupy the space between intrinsic base 112 and dielectric layer 124 before it can completely fill the space between collector 106 and isolation layer 109. Air gap 130, alternatively known as a "cavity," "gas dielectric," and/or similar terms known in the art, thus may have a lower dielectric constant (i.e., it is less conductive) than nearby insulative materials such as isolation layer(s) 109 and dielectric layer 124. Air gap 130 thus may be formed by any currently known or later developed process to create an insulative region of space not filled with dielectric materials and/or other components.

Air gap 130 may have a substantially triangular shape, e.g., where collector 106 and intrinsic base 112 have sloped sidewalls. Air gap 130 may take on different shapes, depending on the shape of collector 106 and intrinsic base 112. In this case, at least a portion of collector 106 is horizontally distal to isolation layer 109 and beneath any undercut portion(s) of dielectric layer 124 and may feature a sloped sidewall. Intrinsic base 112 on collector 106 also may include a sloped sidewall adjacent and/or below air gap 130, e.g., in cases where intrinsic base 112 is formed by epitaxial growth or otherwise formed selectively on collector 106. Semiconductor film 118 also may extend horizontally over dielectric layer 124 to any conceivable length.

Air gap 130 may span, from its lower end, a location horizontally between isolation layer 109 and collector 106, to an upper end between intrinsic base 112 and isolation layer 109. Air gap 130 may be entirely below dielectric layer 124, arising from the smaller separation distance between dielectric layer 124 and intrinsic base 112. Specifically, semiconductor film 118 being formed non-selectively may cause semiconductor film 118 to encapsulate the sidewalls of isolation layer 109, collector 106 and intrinsic base 112. A portion of semiconductor film 118 can span the entire separation distance between intrinsic base 112 and dielectric layer 124, thereby forming and encapsulating air gap 130. Air gap 130 may be desirable as further contributing to electrical isolation between extrinsic bases 116 and collector 106. Air gap 130 in particular may impede or prevent other physical interfaces from forming between extrinsic base 116 and underlying materials other than semiconductor film 118. In some implementations (e.g., where dielectric layer 124 is formed through various other currently known or later developed techniques), air gap 130 instead may be occupied by portions of isolation layer 109 and/or dielectric layer 124.

Emitter 114 may be on semiconductor film 118 and horizontally spaced between extrinsic base(s) 116. In an example, emitter 114 may be horizontally between two extrinsic bases 116. Emitter 114 may be on semiconductor film 118 and above intrinsic base 112, e.g., by forming a stack of materials including portions of extrinsic base(s) 116 over semiconductor film 118, removing a portion of the stack of materials, and forming emitter 114 and/or other components within and/or in place of the removed extrinsic base 116 material as discussed herein. Emitter 114 may have the same doping type as subcollector 102 and collector 106, and thus, has an opposite doping type relative to extrinsic base 116 (and intrinsic base 112, if doped). In the case where bipolar transistor 110 is an NPN device, collector 106 and emitter 114 may be doped n-type to provide the two n-type active semiconductor materials and intrinsic base 112 (including semiconductor film 118 where applicable) may be doped p-type. Emitter 114 may include polycrystalline silicon and/or other monocrystalline semiconductor materials, including one or more materials used elsewhere in structure 100 to form subcollector 102, collector 106, extrinsic base 116 (with different doping), etc.

One or more spacers, e.g., a first spacer 132 and a second spacer 134, may be adjacent emitter 114 to structurally and electrically separate emitter 114 from extrinsic base(s) 116 and/or contacts formed thereto. First spacer 132 and second spacer 134 may have different compositions to control (e.g., increase) the electrical insulation between emitter 114 and nearby portions of extrinsic base 116. For instance, first spacer 132 may be an oxide based insulator formed alongside remaining portions of intrinsic base 112 and second spacer 134 may be a nitride based insulator formed on first spacer 132. Optionally, alternative configurations of first spacer 132 and/or second spacer 134 may be formed (e.g., as discussed in various examples of processing herein) to provide a particular arrangement of insulative materials between extrinsic base 116 and emitter 114. Other compositions and/or arrangements of spacers 132, 134 currently known or later developed also may be used. Spacer(s) 132, 134 thus may include oxide materials, nitride materials, and/or any other insulative material discussed herein, e.g., compositions similar to isolation layer 109 or other insulating structures. Spacer(s) 132, 134 be formed, e.g., by depositing layers of spacer material as part of a stack, removing portions of the stack where emitter 114 is desired, and optionally forming additional portions of spacer 132, 134 material to cover any exposed surfaces and inner sidewalls of extrinsic base 116 before other materials (e.g., emitter 114) are formed adjacent spacers 132, 134 and on a desired portion of semiconductor film 118. In some implementations, spacer(s) 132, 134 may include a single layer or more than two layers.

The position of emitter 114 on semiconductor film 118 may create distinct structural and electrical characteristics in bipolar transistor 110. Emitter 114 may have a particular doping type (e.g., P type doping) opposite that of base(s) 112, 116 (e.g., N type doping). Semiconductor film 118 may be formed to have the same doping type as intrinsic base 112 and extrinsic base 116, e.g., to prevent diode junctions from forming between base(s) 112, 116. The forming of emitter 114 on semiconductor film 118 may include depositing and doping of semiconductor material(s) on semiconductor film 118. Such processes may cause some amount of dopant migration to occur from emitter 114 into semiconductor film 118. The forming of emitter 114 thus may subdivide semiconductor film 118 into two portions, based on the dopants therein. For example, a first portion 118a of semiconductor film 118 beneath emitter 114 may include multiple dopant types: P type doping and N type doping. A second portion 118b of semiconductor film 118 not beneath emitter 114 (i.e., a remainder of semiconductor film 118) may include only one type of doping (e.g., N type doping where bases 112, 116 are also doped N type). The presence of P type doping in first portion 118a may be increase electrical conductivity between emitter 114 and semiconductor film 118 but is not high enough to prevent a diode junction from forming between emitter 114 and intrinsic base 112 where desired. Portions 118a, 118b may be distinguishable based on their relative doping concentrations, but otherwise may include the same semiconductor material(s), e.g., crystalline Si.

Structure 100 may include an inter-level dielectric (ILD) layer 140 over isolation layer 109, extrinsic bases 116, emitter 114, spacers 132, 134, etc. ILD layer 140 may include the same insulating material as isolation layer 109 or may include a different electrically insulative material for vertically separating active materials from overlying materials, e.g., various horizontally extending wires or vias. ILD layer 140 and isolation layer 109 nonetheless constitute different components, e.g., due to isolation layer 109 being vertically between subcollector 102 and the various active components of structure 100. ILD layer 140 may be formed by deposition and/or other techniques to provide electrically insulating materials, and can then be planarized (e.g., using CMP), such that its upper surface remains above any active components formed on subcollector 102.

A set of base contacts 142 through ILD layer 140 may provide the vertical electrical coupling to extrinsic base 116 from overlying metal wires and/or vias. Base contacts 142, notably, do not extend to intrinsic base 112 or semiconductor film 118. Intrinsic base 112 and semiconductor film 118 thus are coupled to base contacts 142 only through extrinsic base 116. Some portions of extrinsic base 116 may be converted into a silicide layer 144 to improve conductivity between each base contact 142 and any portions of extrinsic base 116 thereunder, e.g., by providing a conductive metal such as cobalt (Co), titanium (Ti), nickel (Ni), platinum (Pt), or similar material on the upper surface(s) of a targeted material. The conductive material(s) may be annealed while in contact with the underlying semiconductor to produce silicide layer 144 for electrically coupling semiconductor materials to any contacts formed thereon. Excess conductive material can then be removed using any now known or later developed solution, e.g., etching.

Structure 100 also includes an emitter contact 146 to emitter 114 and a collector contact 148 to collector 106 through subcollector 102. Each contact 146, 148 also may be coupled to emitter 114 or subcollector 102, respectively, through silicide layers 144 formed therein. Each contact 146 also may extend through ILD layer 140, thus collecting active semiconductor material within subcollector 102 or emitter 114 to overlying metal wires, vias, etc., above structure 100. Contact(s) 142, 146, 148 optionally may be formed as part of a single operation, e.g., by removing portions of ILD layer 140 to form openings, forming silicide layers 144 on semiconductor materials exposed within the openings, and filling the openings with metal to define each contact 142, 146, 148. One or more of contacts 142, 146, 148 may include refractory metal liners (not separately shown) on their sidewalls to impede or prevent electromigration degradation, shorting to other components, etc.

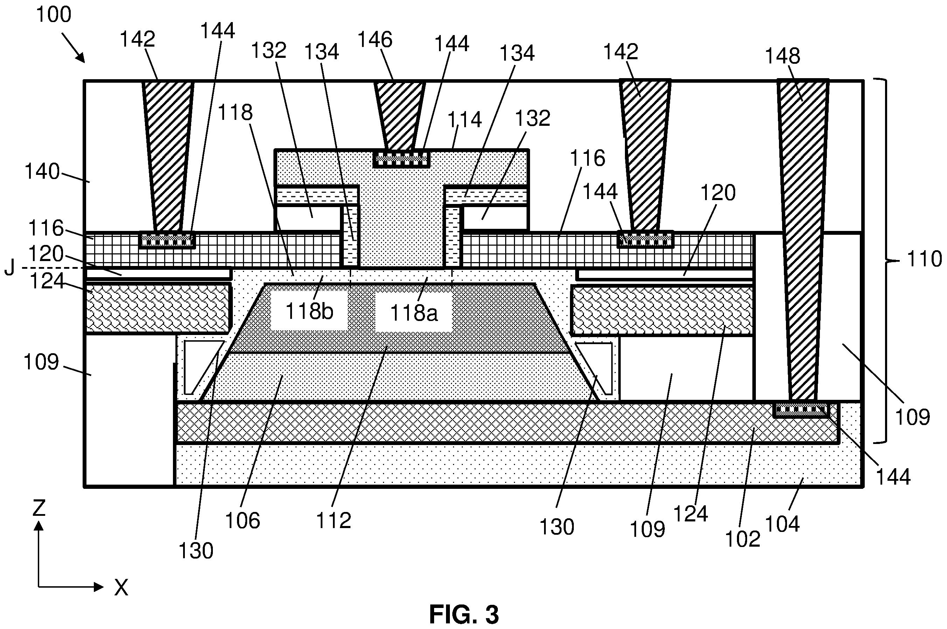

FIG. 3 depicts a further implementation of structure 100 in which bipolar transistor 110 may have a different polarity from other implementations discussed herein, and thus may have certain structural features associated with the different polarity. For example, the embodiment(s) of structure 100 depicted in FIG. 1 may be a "PNP" type bipolar transistor in which base(s) 112, 116 and semiconductor film 118 have N type doping whereas subcollector 102, collector 106, and emitter 114 have P type doping. FIG. 3 depicts an implementation suitable for opposite doping types, e.g., "NPN" type bipolar transistors. Structure 100 may include, e.g., recesses within semiconductor film 118 where insulator film 120 is formed.

In this case, insulator film 120 and semiconductor film 118 may have substantially coplanar upper surfaces along line J, although some portions of semiconductor film 118 may extend above insulator film 120 as discussed elsewhere herein. Extrinsic base 116, here, may have a single planar lower surface extending (e.g., along line J) over semiconductor film 118 and insulator film, instead of having a stepped lower surface as shown in FIG. 1. The recesses within semiconductor film 118 may be formed, e.g., by forming semiconductor film 118 antecedently to precursor materials for emitter 114 and overlying components and using an insulator layer on semiconductor film 118 as an etch stop material during processing. In this case, additional semiconductor film 118 material may be formed within removed portions of the insulator layer such that remaining portions of the insulator define insulator film(s) 120.

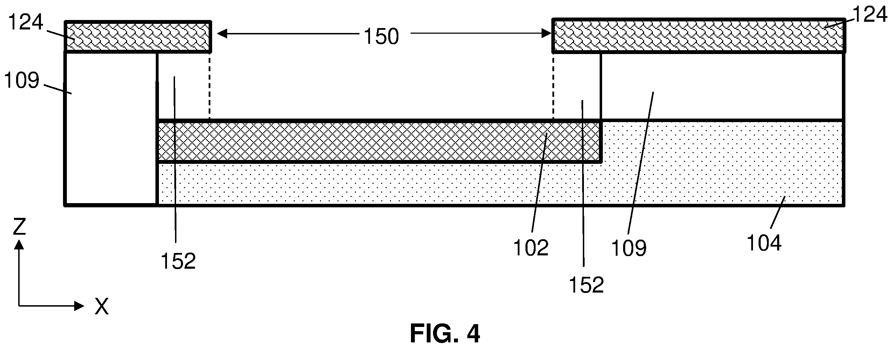

Turning to FIG. 4, methods of forming structure(s) 100 (FIGS. 1-3) according to embodiments of the disclosure are discussed. Initially, only isolation layer 109 and dielectric layer 124 of structure 100 may be located on and/or adjacent subcollector 102. Dielectric layer 124 may be formed, e.g., by deposition of any currently known or later developed dielectric material (e.g., one or more nitride based and/or oxide based insulators) on isolation layer 109. Methods of the disclosure may include forming a trench 150 within isolation layer 109 and dielectric layer 124, e.g., via one or more forms of etching. The process(es) implemented to form trench 150 may terminate at the upper surface of subcollector 102, e.g., by controlling the etch time to form trench 150 and/or by using any currently known or later developed selective etchants operable to remove isolation layer 109 and dielectric layer 124 material(s) without significantly removing or otherwise affecting semiconductor materials (e.g., subcollector 102). The forming of trench 150 may produce undercut regions 152 of isolation layer 109 within trench 150. Undercut regions 152 may be portions of isolation layer 109 that are removed without also removing overlying portions of isolation layer 109, e.g., by continuing to apply selective etchants to isolation layer 109 after subcollector 102 is exposed within trench 150. Undercut regions 152, once formed, may define the sidewall shape of collector 106 and intrinsic base 112 (FIGS. 1-3), e.g., where collector 106 and/or intrinsic base 112 are formed by epitaxial growth within trench 150.

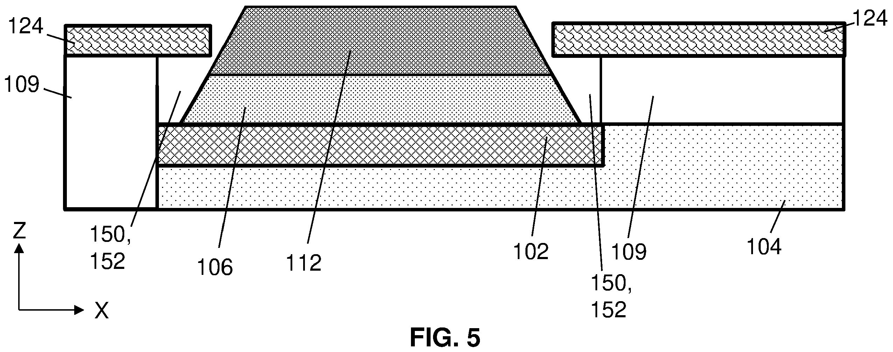

Turning to FIG. 5, further processing may include forming collector 106 and intrinsic base 112 by selective epitaxial growth and/or doping of semiconductor materials within trench 150. As shown, such processing may include forming collector 106 on subcollector 102, in which collector 106 and subcollector 102 have a same doping type but collector 106 has a lower doping concentration. In the case of forming by epitaxial growth, collector 106 may have tapered or otherwise sloped sidewalls within undercut region(s) 152. Further processing may include, e.g., forming intrinsic base 112 as a monocrystalline semiconductor material on collector 106 as a monocrystalline semiconductor material over intrinsic base 112. Intrinsic base 112 may have an opposite doping type from collector 106, and in addition, may have a lower concentration of dopants therein. Collector 106 and/or intrinsic base 112 may be doped through implantation and/or other currently known or later developed doping techniques.

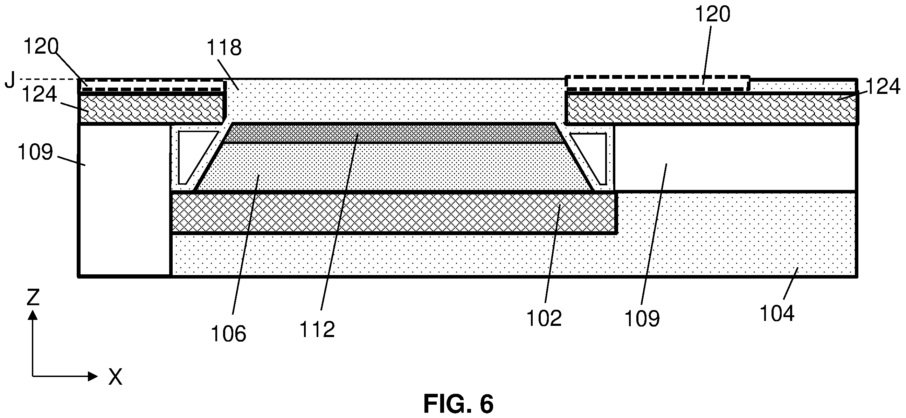

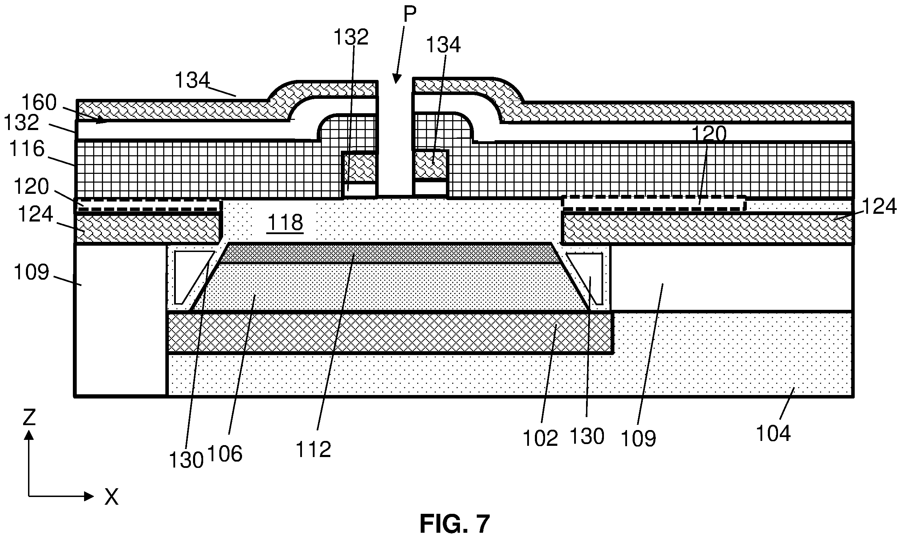

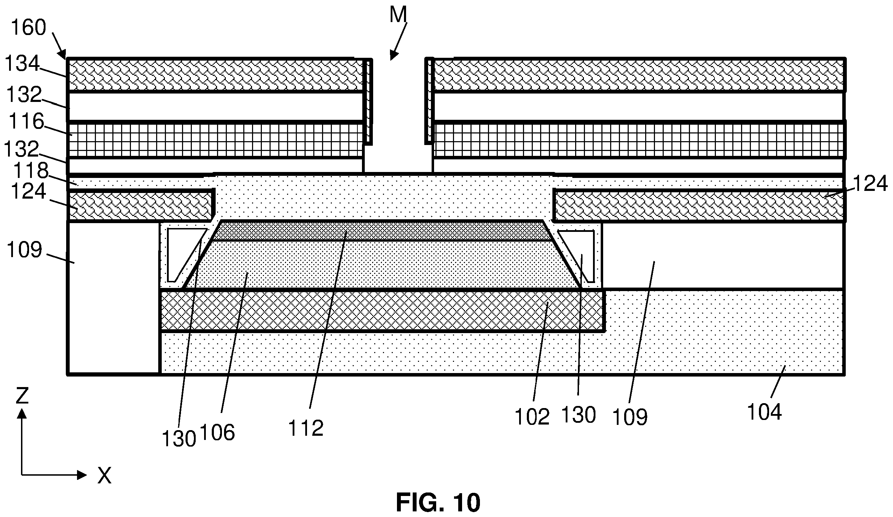

Turning to FIG. 6, further processing may include non-selective forming of semiconductor film 118 (e.g., a layer of semiconductor material, doped during growth or after growth *in situ* to have the same conductivity as intrinsic base 112) with a different composition and/or crystallographic orientation) on intrinsic base 112 and within portions of trench 150 (FIGS. 4, 5). Semiconductor film 118 may only partially fill the space horizontally between isolation layer 109 and the stack of collector 106 and intrinsic base 112, with air gap 130 being defined therein. Air gap 130 may be formed due to the relatively small separation distance between dielectric layer 124 (or similarly positioned materials) and intrinsic base 112, relative to the amount of open space below. Semiconductor film 118 may be doped by any conceivable process, e.g., by thermal anneal after semiconductor film 118 is formed. In the case of doping by thermal anneal, dopants will diffuse into semiconductor film 118 from underlying and/or overlying layers to maintain a significantly low capacitance across semiconductor film 118. For additional protection against shorting, some portions of semiconductor film 118 may be removed to form recesses, and insulator film(s) 120 (shown in dashed lines) optionally may be formed within the recessed areas of semiconductor film 118. In subsequent processing, semiconductor film 118 may function as a part of intrinsic base 112 but also may provide an etch stop layer to control the location and size of emitter 114 (FIGS. 1, 3), as described in various embodiments herein. The resulting partial structure with semiconductor film 118 may be used to form different configurations of structure 100, e.g., PNP or NPN bipolar transistors with structural features shown in, or similar to, the implementations shown in FIGS. 1-3. FIGS. 7-9 illustrate a first processing example and FIGS. 10-13 illustrate a second processing example, but further processing configurations and/or variations of the examples discussed herein are possible.

Referring to FIG. 7, further processing may include forming spacers 132, 134 as layers on semiconductor film 118. Spacers 132, 134 initially may cover semiconductor film 118, but portions of spacers 132, 134 not located over intrinsic base 112 may be removed thereafter by targeted removing (e.g., forming a mask, removing portions of spacers 132, 134 not covered by the mask, and then removing the mask) such that only a portion of spacers 132, 134 remain intact. In some implementations, separately removing targeted portions of spacers 132, 134 can be omitted. In this case, eventual etching to form emitter 114 also can remove targeted portions of spacers 132, 134 to uncover extrinsic base(s) 116. Extrinsic base 116 then can be formed on any re-exposed portions of semiconductor film 118 to a desired height, e.g., by epitaxial growth. Additional layers of spacer 132, 134 material then can be formed on extrinsic base 116, before being selectively removed from locations not above intrinsic base 112 (e.g., by repeating previous operations to remove targeted spacer 132, 134 material). The presence of some spacer 132, 134 material on semiconductor film 118 may cause intrinsic base 116 and overlying spacers 132, 134, to extend upward to a greater height above semiconductor film 118 where they pass over spacer(s) 132, 134 thereunder. An opening P can be formed within extrinsic base 116 and spacers 132, 134. In subsequent processing, emitter 114 (FIGS. 1, 3) can be formed within opening P. The depth of opening P can be controlled, e.g., by using semiconductor film 118 as an etch stop layer and by forming opening P with etchants selective to particular materials (e.g., the composition of extrinsic base 116 and spacers 132, 134), such that semiconductor film 118 is not significantly affected by such etching.

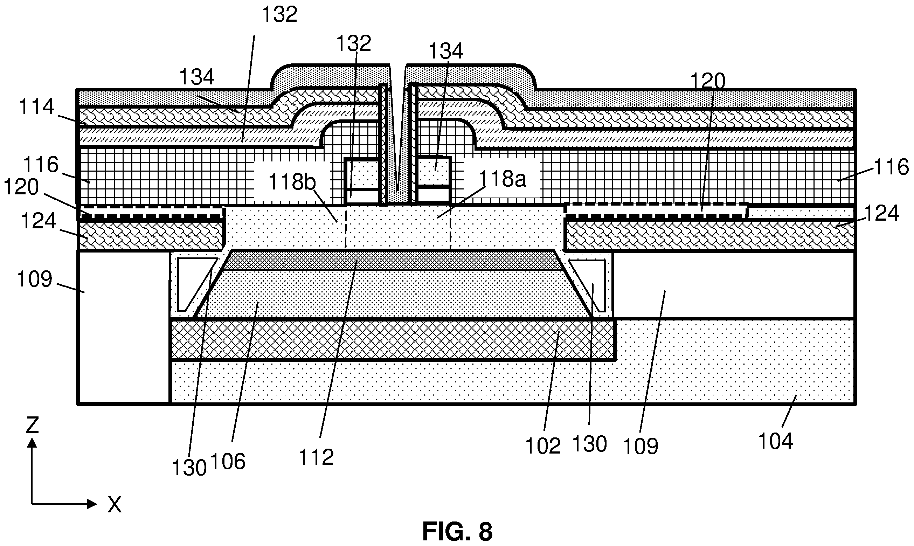

FIG. 8 depicts further processing to form emitter 114, e.g., by deposition on extrinsic base 116 and spacers 132. The forming of emitter 114 may include, e.g., conformal deposition, etching, and doping of semiconductor material such that emitter 114 has a desired size and doping concentration. Emitter 114 may fill opening P (FIG. 7) and depending on the size and shape of opening P, portions of emitter 114 may define a valley within spacers 132, 134 and extrinsic base 116. In some cases, emitter 114 may be formed to a greater height and may be planarized to prevent such valleys from forming, but these additional processes are not required. Emitter 114, initially, may extend completely over extrinsic base 116 beyond locations over collector 106 and intrinsic base 112. The doping of emitter 114 also may cause dopants from emitter 114 to migrate into semiconductor film 118 thereunder. This migration of dopants may subdivide semiconductor film 118 into portions 118a, 118b discussed herein. First portion 118a may include P and N type doping, whereas second portion 118b may include only one doping type (e.g., the same doping type as extrinsic base 116).

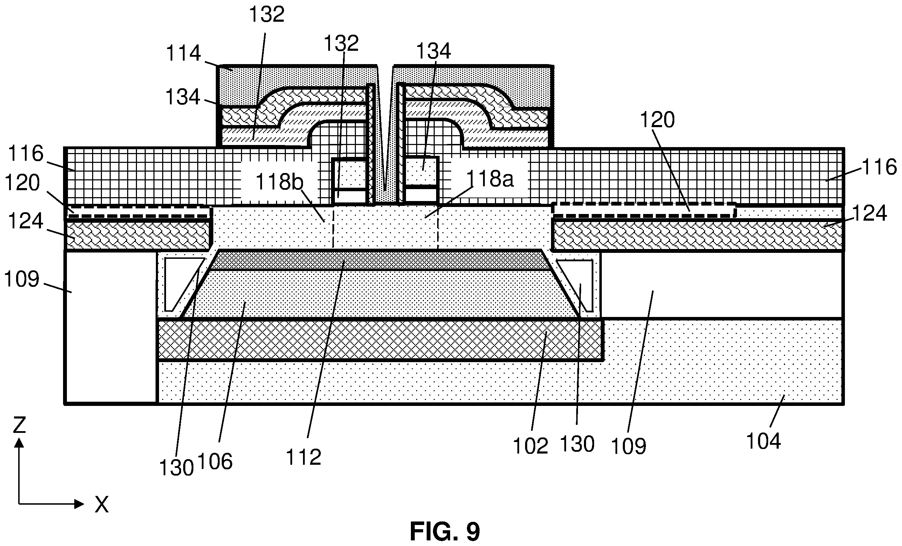

Referring now to FIG. 9, portions of emitter 114 over extrinsic base 116 and not on semiconductor film 118 or spacers 132, 134 may be removed through the use of wet etching and/or other currently known or later developed selective etching materials operable to remove certain doped semiconductor materials (e.g., polycrystalline Si) without removing other semiconductor materials (e.g., monocrystalline or non-crystalline Si). Such processing may be implemented by forming a temporary mask on portions of emitter 114 over intrinsic base 112, applying the etchant(s), and removing the mask. Extrinsic base 116 may remain intact over semiconductor film 118, e.g., to enable forming of contacts to extrinsic base 116 in locations distal to spacer(s) 132, 134.

Referring to FIGS. 1 and 9 together, further processing to form structure 100 (FIGS. 1, 2) may include forming ILD layer 140. With ILD layer 140 in place, structure 100 (FIGS. 1, 2) may be created by forming silicide layer(s) 144 (FIGS. 1, 3), and contact(s) 142, 146, 148) according to conventional processing techniques. The continued presence of semiconductor film 118 dielectric layer(s) 124 may prevent any ILD layer 140 material from entering air gaps 130.

Turning to FIGS. 6 and 10 together, further examples of processing to form structure 100 (FIGS. 1-3) are discussed. The various configurations shown and discussed relative to FIGS. 10-13 herein may be substituted for, or combined with, other techniques to form structure 100 wherever desired or applicable to particular types of devices. The example shown in FIG. 10 *et seq.* may be particularly suitable for "NPN" bipolar transistors. In the example discussed, insulator film(s) 120 are not formed by recessing and deposition on semiconductor film 118, but these operations still may occur in alternative configurations.

Methods of the disclosure may include, e.g., forming a material stack 160 on semiconductor film 118. Material stack 160 may include first spacer 132, followed by extrinsic base 116, and another layer of first spacer 132. An opening M then may be formed by etching material stack 160 where desired, e.g., by forming a temporary mask (not shown) on material stack 160, etching portions of material stack 160 without a mask thereon to form opening M, and removing the mask. Opening M may extend to semiconductor film 118, e.g., by repeated applications of selective and non-selective etching such that semiconductor film 118 remains intact but materials thereover are removed. After opening M is formed, further processing may include forming second spacer 134, e.g., by conformal deposition such that it overlies first spacer 132 and partially coats opening M. Any portions of second spacer 134 formed in lower portions of opening M may be removed, e.g., by directional and/or selective etching to re-expose semiconductor film 118 therein.

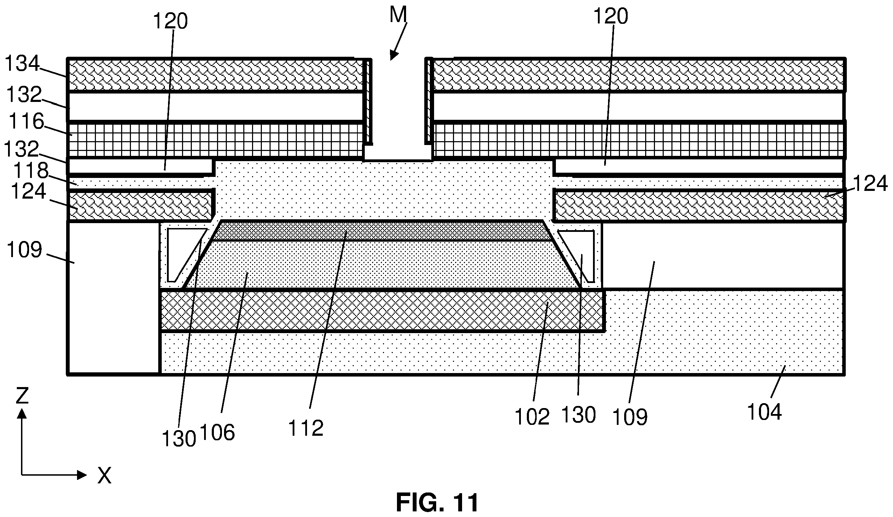

Turning to FIG. 11, further processing may include targeted selective etching of first spacer 132 within opening M. Portions of first spacer 132 located above extrinsic base 116 may be unaffected by such etching due to the earlier forming of second spacer 134 on the sidewalls of opening M. Any removed portions of first spacer 132 within opening M then can be filled with additional portions of semiconductor film 118, e.g., by epitaxial growing of additional semiconductor material within opening M to a desired height and/or growth time. Remaining portions of first spacer 132 located alongside the newly formed semiconductor film 118 may define insulator film(s) 120 on semiconductor film 118 vertically between dielectric layer 124 and extrinsic base 116.

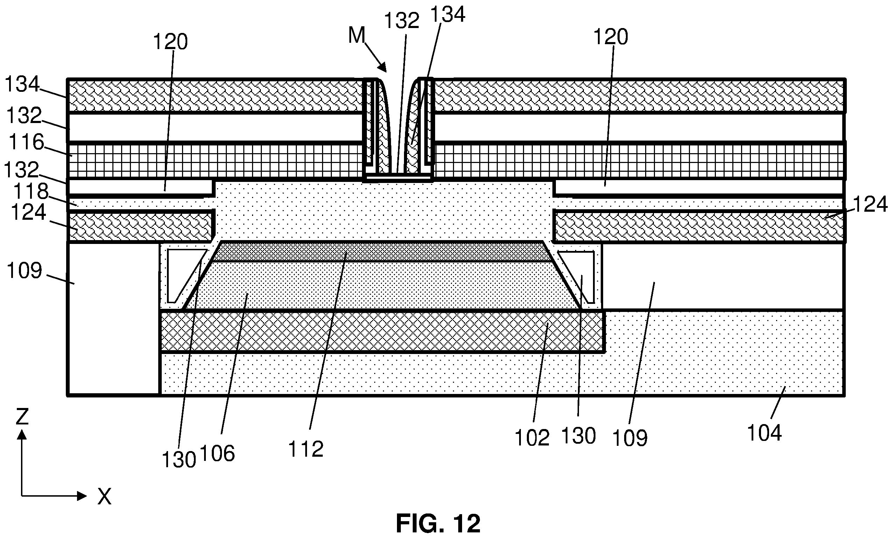

Turning to FIG. 12, further processing may include, e.g., forming an additional layer of first spacer 132 to cover the lower surface and sidewalls of opening M, followed by an additional layer of second spacer 134 to cover sidewalls of first spacer 132 within opening M. The forming of additional spacer(s) 132, 134 may further insulate emitter 114 (FIGS. 1, 3) from other active materials after it is formed within opening M. Any spacer(s) 132, 134 on upper surfaces of previously formed areas of second spacer 134 may be removed, e.g., by planarization, etching, etc.

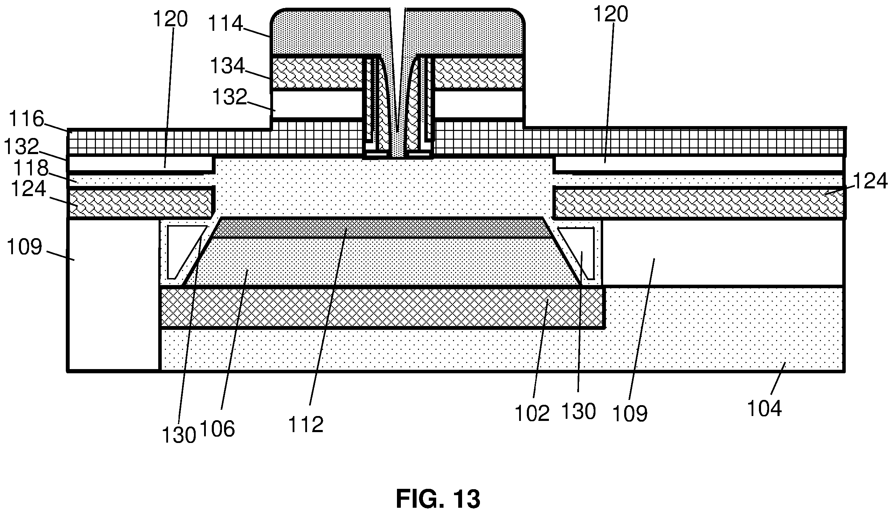

Turning to FIG. 13, continued processing may include removing portions of spacer(s) 132, 134 within opening M (FIGS. 10-12), e.g., by vertical etching, to re-expose a portion of semiconductor film 118 therein, and forming emitter 114 therein. Emitter 114, once formed, may include a valley due to the shape of opening M and the forming of emitter 114 by conformal deposition and/or other similar techniques to provide doped semiconductor material. Portions of spacer(s) 132, 134 and emitter 114 formed horizontally beyond intrinsic base 112 then may be removed by forming a temporary mask on emitter 114 and etching emitter 114 and spacer(s) 132, 134 such that only extrinsic base 116 thereunder is re-exposed. ILD layer 140 and further materials (e.g., silicide layer(s) 144 (FIGS. 1, 3), and contact(s) 142, 146, 148 (FIGS. 1, 3)) then can be formed to yield structure 100.

Embodiments of the disclosure provide various technical and commercial advantages, examples of which are discussed herein. Embodiments of the disclosure are operable to reduce, or altogether prevent, electrical shorting from extrinsic base(s) 116 to collector 106 thereunder by providing semiconductor film 118 as a continuous layer on intrinsic base 112. The shape and presence of semiconductor film 118 also may contribute to vertical electrical insulation within bipolar transistor 110 (FIGS. 1-3) by enabling air gaps 130 to be formed alongside collector 106 and portions of intrinsic base 112. The processing configurations to form embodiments of structure 100, e.g., by including semiconductor film 118, allows extrinsic base 116 to be formed more reliably than comparable processing schemes to provide bipolar transistor(s) 110. Among other benefits, the improved electrical isolation reduces resistance within the base terminal of a transistor and enables better growth of crystalline extrinsic base than may be possible in conventional vertical bipolar transistors. Related technical benefits may include, e.g., reduction in parasitic capacitance between the base(s) and other active portions of a bipolar transistor.

The method and structure as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher-level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. "Optional" or "optionally" means that the subsequently described event or circumstance may or may not occur, and that the description includes instances where the event occurs and instances where it does not.

Approximating language, as used herein throughout the specification and claims, may be applied to modify any quantitative representation that could permissibly vary without resulting in a change in the basic function to which it is related. Accordingly, a value modified by a term or terms, such as "about," "approximately," and "substantially," are not to be limited to the precise value specified. In at least some instances, the approximating language may correspond to the precision of an instrument for measuring the value. Here and throughout the specification and claims, range limitations may be combined and/or interchanged, such ranges are identified and include all the sub-ranges contained therein unless context or language indicates otherwise. "Approximately" as applied to a particular value of a range applies to both values, and unless otherwise dependent on the precision of the instrument measuring the value, may indicate +/-10% of the stated value(s).

The corresponding structures, materials, acts, and equivalents of all means or step plus function elements in the claims below are intended to include any structure, material, or act for performing the function in combination with other claimed elements as specifically claimed. The description of the present disclosure has been presented for purposes of illustration and description but is not intended to be exhaustive or limited to the disclosure in the form disclosed. Many modifications and variations will be apparent to those of ordinary skill in the art without departing from the scope and spirit of the disclosure. The embodiment was chosen and described in order to best explain the principles of the disclosure and the practical application, and to enable others of ordinary skill in the art to understand the disclosure for various embodiments with various modifications as are suited to the particular use contemplated.

In summary, the disclosure provides in various embodiments bipolar transistor structures with a semiconductor film, and related methods. A structure of the disclosure includes an intrinsic base on a collector. The collector has a first doping type. A semiconductor film is on the intrinsic base and horizontally surrounds the intrinsic base. The semiconductor film horizontally encapsulates the intrinsic base. An emitter having the first doping type is on a first portion of the semiconductor film. An extrinsic base having a second doping type is on a second portion of the semiconductor film.

The following embodiments are explicitly disclosed.

### Embodiment 1:

A structure comprising:
an intrinsic base on a collector, wherein the collector has a first doping type;
a semiconductor film on the intrinsic base and horizontally surrounding the intrinsic base;
an emitter having the first doping type on a first portion of the semiconductor film; and
an extrinsic base having a second doping type on a second portion of the semiconductor film.

In some illustrative examples of embodiment 1, the semiconductor film may be vertically interposed between the intrinsic base and each of the emitter and the extrinsic base.

In some illustrative examples of embodiment 1, the structure may additionally or alternatively further comprise:
a subcollector on a semiconductor substrate, wherein the collector is formed on the subcollector and the intrinsic base has the second doping type,; and
a dielectric layer on the subcollector and horizontally distal to the collector, wherein an air gap is between the collector and the dielectric layer, wherein the semiconductor film preferably extends horizontally over the dielectric layer;
wherein the first portion of the semiconductor film includes the first doping type and the second doping type, and
wherein the second portion of the semiconductor film includes only the second doping type.

### Embodiment 2:

The structure of embodiment 1, wherein the first portion of the semiconductor film below the emitter has the first doping type and the second doping type, and a remainder of the semiconductor film includes only the second doping type.

### Embodiment 3:

The structure of embodiment 1 or 2, further comprising an air gap adjacent the collector and the intrinsic base.

In illustrative examples herein, the semiconductor film may encapsulate the air gap and may horizontally surround the collector.

The air gap of embodiment 3 may be identical with the air gap of some illustrative examples disclosed in embodiment 1 above.

### Embodiment 4:

The structure of one of embodiments 1 to 3, wherein the intrinsic base includes silicon germanium (SiGe) and the emitter includes polycrystalline Si.

### Embodiment 5:

The structure of one of embodiments 1 to 4, further comprising an insulator film within a recess on an upper surface of the semiconductor film, wherein a portion of the extrinsic base is on the insulator film.

### Embodiment 6:

The structure of one of embodiments 1 to 5, wherein the semiconductor film extends horizontally over a dielectric layer.

### Embodiment 7:

The structure of one of embodiments 1 to 6, wherein a lower surface of the emitter is substantially coplanar with a lower surface of the extrinsic base, and/or
wherein the semiconductor film is vertically interposed between the intrinsic base and each of the emitter and the extrinsic base.

### Embodiment 8:

A structure comprising:
a subcollector on a semiconductor substrate;
a collector on the subcollector, the collector having a first doping type;
an intrinsic base on the collector, the intrinsic base having a second doping type;
a semiconductor film on the intrinsic base and horizontally surrounding the intrinsic base;
a dielectric layer on the subcollector and horizontally distal to the collector, wherein an air gap is between the collector and the dielectric layer;
an emitter having the first doping type on a first portion of the semiconductor film, wherein the first portion of the semiconductor film includes the first doping type and the second doping type; and
an extrinsic base having the second doping type on a second portion of the semiconductor film, wherein the second portion of the semiconductor film includes only the second doping type. Alternatively, embodiment 8 may depend on embodiment 1 in that embodiment 8 represents the structure of one of embodiments 1 to 7, further comprising:
a subcollector on a semiconductor substrate, wherein the collector is formed on the subcollector and the intrinsic base has the second doping type,; and
a dielectric layer on the subcollector and horizontally distal to the collector, wherein an air gap is between the collector and the dielectric layer, wherein the semiconductor film preferably extends horizontally over the dielectric layer;
wherein the first portion of the semiconductor film includes the first doping type and the second doping type, and
wherein the second portion of the semiconductor film includes only the second doping type.

### Embodiment 9:

The structure of embodiment 8, wherein the semiconductor film is vertically interposed between the intrinsic base and each of the emitter and the extrinsic base.

### Embodiment 10:

The structure of embodiment 8 or 9, wherein a portion of the semiconductor film encapsulates the air gap and horizontally surrounds the collector.

### Embodiment 11:

The structure of one of embodiments 8 to 10, wherein the intrinsic base includes silicon germanium (SiGe) and the emitter includes polycrystalline Si.

### Embodiment 12:

The structure of one of embodiments 8 to 11, further comprising an insulator film within a recess on an upper surface of the semiconductor film, wherein a portion of the extrinsic base is on the insulator film.

### Embodiment 13:

The structure of one of embodiments 8 to 12, wherein the semiconductor film extends horizontally over the dielectric layer.

### Embodiment 14:

The structure of one of embodiments 8 to 13, wherein a lower surface of the emitter is substantially coplanar with a lower surface of the extrinsic base.

### Embodiment 15:

A method comprising:
forming an intrinsic base on a collector, wherein the collector has a first doping type;
forming a semiconductor film on the intrinsic base and horizontally surrounding the intrinsic base;
forming an emitter having the first doping type on a first portion of the semiconductor film; and
forming an extrinsic base having a second doping type on a second portion of the semiconductor film.

### Embodiment 16:

The method of embodiment 15, wherein the first portion of the semiconductor film below the emitter has the first doping type and the second doping type, and a remainder of the semiconductor film includes only the second doping type.

Embodiment 17: 17. The method of embodiment 15 or 16, wherein the intrinsic base includes silicon germanium (SiGe) and the emitter includes polycrystalline Si.

### Embodiment 18:

The method of one of embodiments 15 to 17, wherein the semiconductor film is formed by non-selective epitaxial growth on the intrinsic base.

### Embodiment 19:

The method of one of embodiments 15 to 18, further comprising forming a dielectric layer horizontally distal to the semiconductor film, wherein the semiconductor film extends horizontally over the dielectric layer.

### Embodiment 20:

The method of one of embodiments 15 to 19, wherein a lower surface of the emitter is substantially coplanar with a lower surface of the extrinsic base.

### Embodiment 21:

The method of one of embodiments 15 to 20, wherein the structure of one of embodiments 1 to 14 is formed.

The structures of the embodiments disclosed above may be bipolar transistor structures.

## Claims

1. A structure comprising:
an intrinsic base on a collector, wherein the collector has a first doping type;
a semiconductor film on the intrinsic base and horizontally surrounding the intrinsic base;
an emitter having the first doping type on a first portion of the semiconductor film; and
an extrinsic base having a second doping type on a second portion of the semiconductor film.

2. The structure of claim 1, wherein the first portion of the semiconductor film below the emitter has the first doping type and the second doping type, and a remainder of the semiconductor film includes only the second doping type.

3. The structure of claim 1 or 2, further comprising an air gap adjacent the collector and the intrinsic base, wherein the semiconductor film preferably encapsulates the air gap and preferably horizontally surrounds the collector.

4. The structure of one of claims 1 to 3, wherein the intrinsic base includes silicon germanium (SiGe) and the emitter includes polycrystalline Si.

5. The structure of one of claims 1 to 4, further comprising an insulator film within a recess on an upper surface of the semiconductor film, wherein a portion of the extrinsic base is on the insulator film.

6. The structure of one of claims 1 to 5, wherein the semiconductor film extends horizontally over a dielectric layer.

7. The structure of one of claims 1 to 6, wherein a lower surface of the emitter is substantially coplanar with a lower surface of the extrinsic base.

8. The structure of one of claims 1 to 7, wherein the semiconductor film is vertically interposed between the intrinsic base and each of the emitter and the extrinsic base.

9. The structure of one of claims 1 to 8, further comprising:
a subcollector on a semiconductor substrate, wherein the collector is formed on the subcollector and the intrinsic base has the second doping type,; and
a dielectric layer on the subcollector and horizontally distal to the collector, wherein an air gap is between the collector and the dielectric layer, wherein the semiconductor film preferably extends horizontally over the dielectric layer;
wherein the first portion of the semiconductor film includes the first doping type and the second doping type, and
wherein the second portion of the semiconductor film includes only the second doping type.

10. The structure of claim 9, wherein a portion of the semiconductor film encapsulates the air gap and horizontally surrounds the collector.

11. A method comprising:
forming an intrinsic base on a collector, wherein the collector has a first doping type;
forming a semiconductor film on the intrinsic base and horizontally surrounding the intrinsic base;
forming an emitter having the first doping type on a first portion of the semiconductor film; and
forming an extrinsic base having a second doping type on a second portion of the semiconductor film.

12. The method of claim 11, wherein the first portion of the semiconductor film below the emitter has the first doping type and the second doping type, and a remainder of the semiconductor film includes only the second doping type.

13. The method of claim 11 or 12, wherein the intrinsic base includes silicon germanium (SiGe) and the emitter includes polycrystalline Si.

14. The method of one of claims 11 to 13,
wherein the semiconductor film is formed by non-selective epitaxial growth on the intrinsic base, and/or
wherein a lower surface of the emitter is substantially coplanar with a lower surface of the extrinsic base.

15. The method of one of claims 11 to 14, further comprising forming a dielectric layer horizontally distal to the semiconductor film, wherein the semiconductor film extends horizontally over the dielectric layer.
